# EUROPEAN PATENT APPLICATION

(11) **EP 4 692 844 A1**
(43) Date of publication of application: **11.02.2026**
(21) Application number: 24778796.3
(22) Date of filing: 15.02.2024
(51) Int. Cl.: G01S 7/487, G01S 17/894, H01L 31/107, H04N 25/705, H04N 25/773

(54) **LIGHT DETECTION DEVICE AND DISTANCE MEASUREMENT SYSTEM**

(30) Priority: 30.03.2023 JP 2023056325
(71) Applicant: Sony Semiconductor Solutions Corporation, Atsugi-shi, Kanagawa 243-0014 (JP)
(72) Inventor: LIU Yuqing, Atsugi-shi, Kanagawa 243-0014 (JP); HOSOYA Masahiro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/005265
(87) International publication number: WO 2024/202651

(57) **Abstract**

The present disclosure provides a photodetection device and a distance measuring system capable of suppressing a decrease in photodetection accuracy.

A photodetection device (30) according to an embodiment of the present disclosure includes: a photoelectric conversion element (331a) that photoelectrically converts incident light; a comparator (331c) that compares an output voltage of the photoelectric conversion element with a threshold voltage (Vth); a pulse generation circuit (335) that uses a pixel signal (OUT_REP) indicating a comparison result by the comparator to generate a pulse signal (TRIG) having a pulse width shorter than a pulse width of the pixel signal; and a switch (336) that is connected to the photoelectric conversion element (331a) and is turned on and off on the basis of the pulse signal (TRIG).

## Description

### TECHNICAL FIELD

The present disclosure relates to a photodetection device and a distance measuring system.

### BACKGROUND ART

As a method of measuring a distance to a subject, a time of flight (ToF) method is used. In the ToF method, light emitted from a light source is reflected by the subject, and the reflected light is photoelectrically converted. Subsequently, the distance to the subject is measured on the basis of a time from when the light is emitted to when the reflected light is photoelectrically converted.

A distance measuring system using the ToF method is generally provided with a photodetection device that photoelectrically converts the reflected light described above. In the photodetection device, reflected light is received by an avalanche photodiode such as a single photon avalanche diode (SPAD). A voltage waveform of the avalanche photodiode is converted into a pulse signal by an inverter element. The pulse signal is accumulated as a histogram. A flight time of light is obtained on the basis of shape information such as a peak position of the histogram.

### CITATION LIST

### PATENT DOCUMENT

Patent Document 1: Japanese Patent Application Laid-Open No. 2020-148562

### SUMMARY OF THE INVENTION

### PROBLEMS TO BE SOLVED BY THE INVENTION

When a threshold voltage of the inverter element varies depending on a process (P), a voltage (V), and a temperature (T), an output pulse width of the inverter element also varies. In this case, since a shape of the histogram also changes, photodetection accuracy may decrease.

The present disclosure provides a photodetection device and a distance measuring system capable of suppressing a decrease in photodetection accuracy.

### SOLUTIONS TO PROBLEMS

A photodetection device according to an embodiment of the present disclosure includes: a photoelectric conversion element that photoelectrically converts incident light; a comparator that compares an output voltage of the photoelectric conversion element with a threshold voltage; a pulse generation circuit that uses a pixel signal indicating a comparison result by the comparator to generate a pulse signal having a pulse width shorter than a pulse width of the pixel signal; and a switch that is connected to the photoelectric conversion element and is turned on and off on the basis of the pulse signal.

The photodetection device
may further include:
a pixel circuit including a first photoelectric conversion element that photoelectrically converts the incident light and a first comparator that compares an output voltage of the first photoelectric conversion element with a threshold voltage, the pixel circuit outputting a first pixel signal indicating a comparison result by the first comparator; and
a pixel replica circuit including a second photoelectric conversion element connected to the switch and a second comparator that compares an output voltage of the second photoelectric conversion element with the threshold voltage, in which a second pixel signal indicating a comparison result by the second comparator is input to the pulse generation circuit.

The photodetection device may further include a control circuit that controls a potential of the threshold voltage on the basis of a result of counting the second pixel signal within a certain period.

The control circuit may increase the potential of the threshold voltage when the number of counts of the second pixel signal is larger than a predetermined number of counts.

The control circuit may decrease the potential of the threshold voltage when the number of counts of the second pixel signal is smaller than a predetermined number of counts.

The photodetection device may further include:
a counter circuit that measures the number of the second pixel signals; and
a digital analog converter (DAC) that adjusts the potential of the threshold voltage in accordance with control of the control circuit.

The photodetection device may further include:
a pulse width adjustment circuit that outputs a calibrated signal obtained by adjusting a pulse width of the pixel signal to the pulse generation circuit; and
a control circuit that causes the pulse width adjustment circuit to adjust the pulse width on the basis of a result of counting the calibrated signal within a certain period.

The pulse width adjustment circuit
may include:
a delay circuit that outputs the pixel signal input, as a delay signal after a lapse of a delay time; and
an OR circuit that performs an OR logic operation on the pixel signal and the delay signal.

The control circuit may control the delay time on the basis of a result of counting the calibrated signal.

The control circuit may lengthen the delay time when the number of counts of the calibrated signal is larger than a predetermined number of counts.

The control circuit may shorten the delay time when the number of counts of the calibrated signal is smaller than a predetermined number of counts.

The photodetection device may further include:
a first semiconductor substrate on which the photoelectric conversion element is disposed; and
a second semiconductor substrate on which the comparator, the pulse generation circuit, and the switch are disposed, the second semiconductor substrate being stacked and bonded to the first semiconductor substrate.

The photoelectric conversion element may be an avalanche photodiode.

A cathode of the photoelectric conversion element may be connected to a positive input terminal of the comparator.

A cathode of the photoelectric conversion element may be connected to a negative input terminal of the comparator.

An anode of the photoelectric conversion element may be connected to a negative input terminal of the comparator.

The photodetection device may further include a control circuit that controls a potential of the threshold voltage in accordance with a light receiving environment of the photoelectric conversion element.

The control circuit may determine the light receiving environment as a first light receiving environment or a second light receiving environment in which disturbance light is stronger than in the first light receiving environment and a distance to a subject is shorter, on the basis of an average value of a histogram of the pixel signal within a certain period, and
the control circuit may increase the potential of the threshold voltage when the light receiving environment is the first light receiving environment and decrease the potential of the threshold voltage when the light receiving environment is the second light receiving environment.

A distance measuring system according to an embodiment of the present disclosure includes: a light source device that emits light toward a subject; and a photodetection device that receives reflected light obtained by reflection of the light on the subject.

The photodetection device includes:
a photoelectric conversion element that photoelectrically converts the reflected light;
a comparator that compares an output voltage of the photoelectric conversion element with a threshold voltage;
a pulse generation circuit that uses a pixel signal indicating a comparison result by the comparator to generate a pulse signal having a pulse width shorter than a pulse width of the pixel signal; and
a switch that is connected to the photoelectric conversion element and is turned on and off on the basis of the pulse signal.

### BRIEF DESCRIPTION OF DRAWINGS

Fig. 1 is a diagram for explaining a distance measuring method by a distance measuring system according to a first embodiment.
Fig. 2 is a block diagram illustrating an example of a configuration of a distance measuring system.
Fig. 3 is a circuit diagram of a distance measurement circuit and a reference voltage generation circuit.
Fig. 4 is a timing chart for explaining operation of a pixel circuit.
Fig. 5 is a timing chart for explaining calibration operation of the reference voltage generation circuit.
Fig. 6 is a circuit diagram of a comparator according to the first embodiment.
Fig. 7 is a flowchart for explaining operation of the comparator and an inverter element.
Fig. 8 is a circuit diagram of a pixel according to a modification of the first embodiment.
Fig. 9 is a circuit diagram of the comparator according to the modification.
Fig. 10 is a flowchart for explaining operation of the comparator according to the modification.
Fig. 11 is a block diagram illustrating a configuration of a main part of a photodetection device according to a second embodiment.
Fig. 12 is a circuit diagram of a pulse width adjustment circuit.
Fig. 13 is a diagram illustrating an example of signal waveforms input to and output from the pulse width adjustment circuit.
Fig. 14 is a timing chart for explaining calibration operation of a distance measurement circuit.
Fig. 15 is a perspective view illustrating an example of a structure of a photodetection device according to a third embodiment.
Fig. 16 is a circuit diagram of the pixel circuit according to a fourth embodiment.
Fig. 17 is a circuit diagram illustrating a configuration of a photodetection device according to a fifth embodiment.
Fig. 18 is a timing chart for explaining operation of the photodetection device in a first light receiving environment.
Fig. 19 is a timing chart for explaining operation of the photodetection device in a second light receiving environment.
Fig. 20 is a circuit diagram of a comparator according to a sixth embodiment.
Fig. 21 is a diagram illustrating an example of a voltage waveform when a MOS transistor N2 is degraded in the comparator according to the first embodiment.
Fig. 22 is a diagram illustrating an example of a voltage waveform when the MOS transistor N2 is degraded in the comparator according to the sixth embodiment.
Fig. 23 is a block diagram illustrating an example of a schematic configuration of a vehicle control system.
Fig. 24 is an explanatory diagram illustrating an example of installation positions of an outside-vehicle information detecting section and an imaging section.

### MODE FOR CARRYING OUT THE INVENTION

### (First Embodiment)

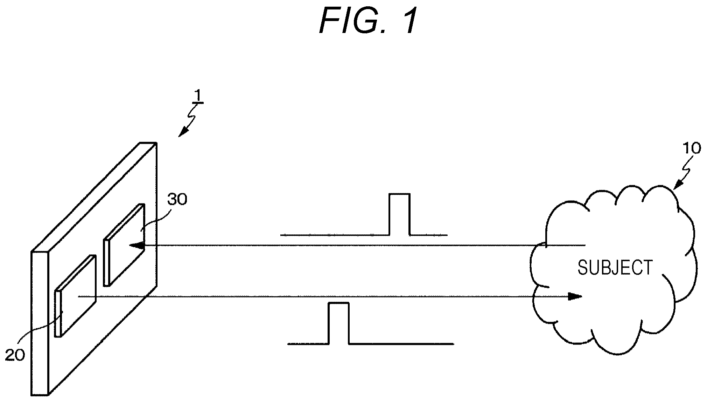

Fig. 1 is a diagram for explaining a distance measuring method by a distance measuring system according to a first embodiment. A distance measuring system 1 according to the present embodiment adopts a time of flight (TOF) method of measuring a time until light (for example, laser light) emitted toward a subject 10 is reflected by the subject 10 and returns, as a distance measuring method to the subject 10 as a measurement target.

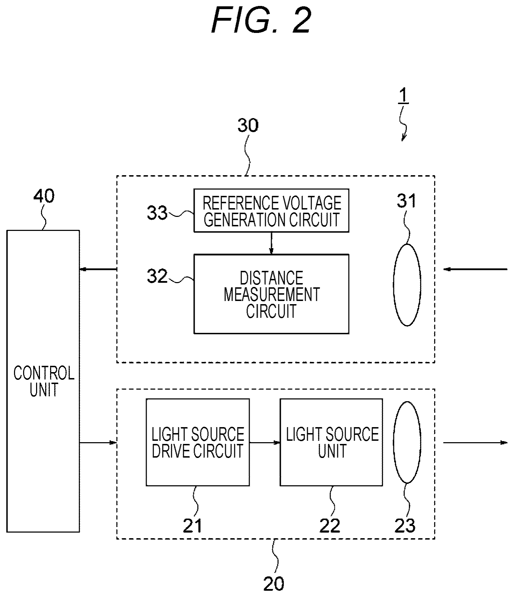

Fig. 2 is a block diagram illustrating an example of a configuration of the distance measuring system 1. In order to implement distance measurement by the TOF method described above, the distance measuring system 1 according to the present embodiment includes a light source device 20, a photodetection device 30, and a control unit 40.

The light source device 20 includes, for example, a light source drive circuit 21, a light source unit 22, and a diffusion lens 23. The light source drive circuit 21 drives the light source unit 22 under control of the control unit 40. The light source unit 22 includes, for example, a semiconductor laser. The light source unit 22 emits pulsed laser light by driving the light source drive circuit 21. The diffusion lens 23 diffuses the laser light emitted from the light source unit 22, and emits the laser light toward the subject 10.

The photodetection device 30 includes a light receiving lens 31, a distance measurement circuit 32, and a reference voltage generation circuit 33, and receives reflected laser light, which is returned after the laser light emitted by the light source device 20 is reflected by the subject 10, as incident light. The light receiving lens 31 condenses the reflected laser light from the subject 10 on a light receiving surface of the distance measurement circuit 32. The distance measurement circuit 32 receives the reflected laser light from the subject 10 through the light receiving lens 31 in units of pixels, and photoelectrically convert the reflected laser light. Furthermore, the distance measurement circuit 32 measures the number of times of reaction to the reflected laser light by using a photoelectrically converted signal. Moreover, the distance measurement circuit 32 generates a histogram of the number of times of reaction.

The reference voltage generation circuit 33 generates a threshold voltage Vth used when the distance measurement circuit 32 photoelectrically converts the reflected laser light, and outputs the threshold voltage Vth to the distance measurement circuit 32. Note that circuit configurations of the distance measurement circuit 32 and the reference voltage generation circuit 33 will be described later.

The control unit 40 includes, for example, a central processing unit (CPU) and the like, and controls the light source device 20 and the photodetection device 30.

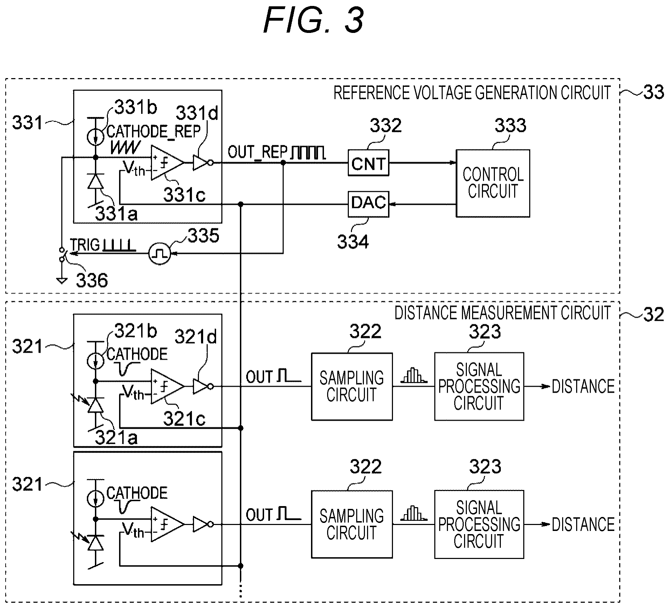

Fig. 3 is a circuit diagram of the distance measurement circuit 32 and the reference voltage generation circuit 33. First, a description will be given of the circuit configuration of the distance measurement circuit 32.

The distance measurement circuit 32 includes a plurality of pixel circuits 321, a plurality of sampling circuits 322, and a plurality of signal processing circuits 323. The plurality of pixel circuits 321 is arranged in a two-dimensional array. The sampling circuits 322 are disposed at the subsequent stage of the pixel circuits 321. The signal processing circuits 323 are disposed at the subsequent stage of the sampling circuits 322.

Each pixel circuit 321 includes a photoelectric conversion element 321a (first photoelectric conversion element), a current source 321b, a comparator 321c (first comparator), and an inverter element 321d. The photoelectric conversion element 321a is an avalanche photodiode represented by a SPAD, for example. The cathode of the photoelectric conversion element 321a is connected to the current source 321b and the positive input terminal (+) of the comparator 321c. A negative voltage at which avalanche multiplication occurs is applied to the anode of the photoelectric conversion element 321a.

The current source 321b supplies a constant current to the photoelectric conversion element 321a when a cathode voltage CATHODE output from the photoelectric conversion element 321a reaches a breakdown voltage. As a result, the cathode voltage CATHODE of the photoelectric conversion element 321a rises.

The comparator 321c compares the cathode voltage CATODE of the photoelectric conversion element 321a with the threshold voltage Vth. The threshold voltage Vth is input from the reference voltage generation circuit 33 to the negative input terminal (-). When the cathode voltage CATODE is higher than the threshold voltage Vth, a voltage level of the output terminal of the comparator 321c is a high level. On the other hand, when the cathode voltage CATODE is lower than the threshold voltage Vth, the voltage level of the output terminal of the comparator 321c is a low level.

The inverter element 321d inverts a voltage level of an output signal of the comparator 321c. An inverted signal is input to the sampling circuit 322 as a pulsed pixel signal OUT (first pixel signal). Note that the inverter element 321d may not be provided.

The sampling circuit 322 performs, for example, time to digital converter (TDC) processing and histogram generation processing. In the TDC processing, the sampling circuit 322 digitally converts an occurrence time of a transition timing of a voltage level of the pixel signal OUT. In the histogram generation processing, the sampling circuit 322 measures the number of times of acquisition of a digital value converted by the TDC processing, that is, the number of times of reaction of the pixel circuit 321 to the incident light. Since the TDC processing is executed a plurality of times, the histogram generated by the histogram processing is obtained by integration of the number of times of reaction measured a plurality of times by the pixel circuit 321.

On the basis of a peak position of the histogram generated by the sampling circuit 322, the signal processing circuit 323 specifies a time t until the laser light emitted from the light source device 20 toward the subject 10 is reflected by the subject 10 and returns. A distance L from the distance measuring system 1 to the subject 10 can be obtained on the basis of the time t.

Next, a description will be given of the circuit configuration of the reference voltage generation circuit 33. The reference voltage generation circuit 33 is a circuit for performing calibration of the threshold voltage Vth, and includes a pixel replica circuit 331, a counter circuit 332, a control circuit 333, a digital analog converter (DAC) 334, a pulse generation circuit 335, and a switch 336.

The pixel replica circuit 331 includes a photoelectric conversion element 331a (second photoelectric conversion element), a current source 331b, a comparator 331c (second comparator), and an inverter element 331d. The pixel replica circuit 331 is a circuit obtained by replication of the pixel circuit 321 described above. For that reason, circuit elements and element arrangement of the pixel replica circuit 331 are the same as those of the pixel circuit 321. In the pixel replica circuit 331, the comparator 331c compares a cathode voltage CATHODE _REP of the photoelectric conversion element 331a with the threshold voltage Vth. Furthermore, the inverter element 331d inverts an output signal of the comparator 331c. An inverted signal is input to the counter circuit 332 as a pulsed pixel signal OUT_REP (second pixel signal).

The counter circuit 332 measures the number of the pixel signals OUT_REP input within a certain period. Furthermore, the counter circuit 332 outputs a measurement result to the control circuit 333.

The control circuit 333 adjusts a potential of the threshold voltage Vth output from the DAC 334 in accordance with the measurement result by the counter circuit 332.

The DAC 334 generates the threshold voltage Vth of the potential set by the control circuit 333. The generated threshold voltage Vth is input to each of the negative input terminal (-) of the comparator 331c of the pixel replica circuit 331 and the negative input terminal (-) of the comparator 331c of each pixel circuit 321.

The pulse generation circuit 335 outputs a pulse signal TRIG on the basis of the pixel signal OUT_REP of the pixel replica circuit 331. A pulse width of the pulse signal TRIG is shorter than a pulse width of the pixel signal OUT_REP.

The switch 336 is connected to the cathode of the photoelectric conversion element 331a. The switch 336 includes, for example, an n-channel MOS transistor. The pulse signal TRIG is input to the gate of the MOS transistor. The switch 336 is turned on when the pulse signal TRIG is at the high level. Conversely, the switch 336 is turned off when the pulse signal TRIG is at the low level. When the switch 336 is in an on state, charges accumulated in the photoelectric conversion element 331a are discharged.

Next, a description will be given of operation of the photodetection device 30 according to the present embodiment configured as described above. Here, a description will be given of operation of the pixel circuit 321 and calibration operation of the reference voltage generation circuit 33.

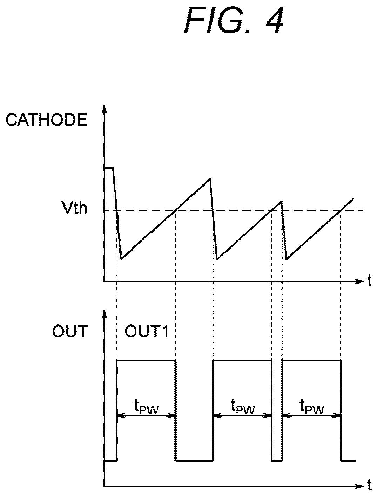

Fig. 4 is a timing chart for explaining the operation of the pixel circuit 321. Fig. 4 illustrates a waveform of each of the cathode voltage CATHODE of the photoelectric conversion element 321a and the pixel signal OUT. In an initial state, the cathode voltage CATHODE of the photoelectric conversion element 321a is held at a certain voltage value. When the photoelectric conversion element 321a detects light, an avalanche current flows, so that the cathode voltage CATHODE decreases.

When the cathode voltage CATHODE becomes lower than the threshold voltage Vth, the pixel signal OUT rises from the low level to the high level. Thereafter, when a potential difference between the anode and the cathode of the photoelectric conversion element 321a reaches the breakdown voltage, the avalanche current stops. Thereafter, when the current source 321b supplies a current to the photoelectric conversion element 321a, the cathode voltage CATHODE starts to rise.

When the cathode voltage CATHODE becomes higher than the threshold voltage Vth, the pixel signal OUT falls from the high level to the low level. In the pixel signal OUT, a time from the rise to the fall corresponds to a pulse width t_{pw}.

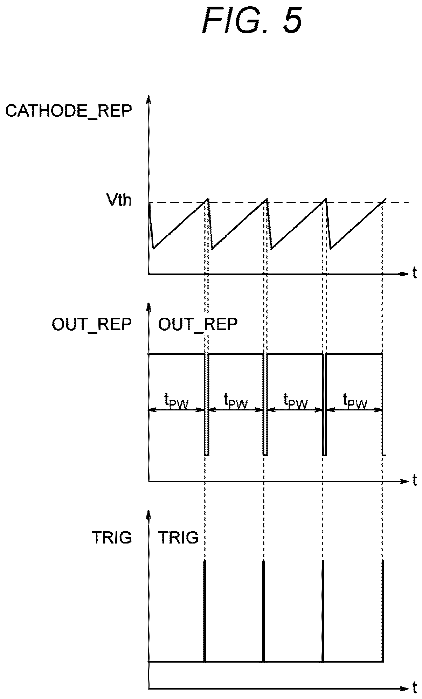

Fig. 5 is a timing chart for explaining the calibration operation of the reference voltage generation circuit 33. Fig. 5 illustrates a waveform of each of the cathode voltage CATHODE _REP of the photoelectric conversion element 331a, the pixel signal OUT_REP, and the pulse signal TRIG.

In the reference voltage generation circuit 33, the pixel signal OUT_REP falls at a timing when the cathode voltage CATHODE _REP of the photoelectric conversion element 331a becomes higher than the threshold voltage Vth. At a timing when the pixel signal OUT_REP falls, the pulse generation circuit 335 outputs the pulse signal TRIG to the switch 336.

The switch 336 is turned on in a period in which the pulse signal TRIG is at the high level. As a result, the cathode voltage CATHODE_REP is reset to 0 V. Furthermore, the pulse width of the pulse signal TRIG is shorter than that of the pixel signal OUT_REP. For that reason, the pixel signal OUT_REP immediately rises after falling.

Subsequently, when the current source 331b supplies a current to the photoelectric conversion element 331a, the cathode voltage CATHODE _REP starts to rise. Thereafter, when the cathode voltage CATHODE _REP becomes higher than the threshold voltage Vth, the pixel signal OUT_REP falls again.

The operation described above is repeated, whereby the pixel signal OUT_REP is generated as a clock signal of a constant period. The counter circuit 332 measures the number of the pixel signals OUT_REP within a certain period.

The control circuit 333 adjusts the threshold voltage Vth, which is an output voltage of the DAC 334, so that the number of counts of the pixel signal OUT_REP is a predetermined number of counts. For example, when the number of the pixel signals OUT_REP measured by the counter circuit 332 is larger than the predetermined number of counts, the control circuit 333 increases the potential of the threshold voltage Vth (causes the potential to rise). On the other hand, when the number of the pixel signals OUT_REP is smaller than the predetermined number of counts, the control circuit 333 decreases the potential of the threshold voltage Vth (cause the potential to fall). As a result, the pulse width t_{pw} of the pixel signal OUT_REP of the pixel replica circuit 331 can be made constant. The threshold voltage Vth is also input to the negative input terminal (-) of the comparator 321c of each pixel circuit 321. For that reason, the pulse width t_{pw} of the pixel signal OUT of each pixel circuit 321 can also be made constant.

In the present embodiment, the reference voltage generation circuit 33 is provided with the pixel replica circuit 331 having the same circuit configuration as that of the pixel circuit 321. It is possible to measure the pulse width t_{pw} by connecting the switch 336 for discharge to the cathode of the photoelectric conversion element 331a of the pixel replica circuit 331, causing an output signal of the pixel replica circuit 331 to oscillate, and measuring an oscillation frequency.

Furthermore, the control circuit 333 adjusts the potential of the threshold voltage Vth, whereby it is possible to perform calibration of the pulse width t_{pw} of output signals of the reference voltage generation circuit 33 and each pixel circuit 321. As a result, the pulse width t_{pw} of the pixel signal OUT, which is the output signal of each pixel circuit 321, can be made constant regardless of the conditions of a process, a voltage, and a temperature. Thus, it is possible to suppress a decrease in photodetection accuracy and to improve distance measurement accuracy.

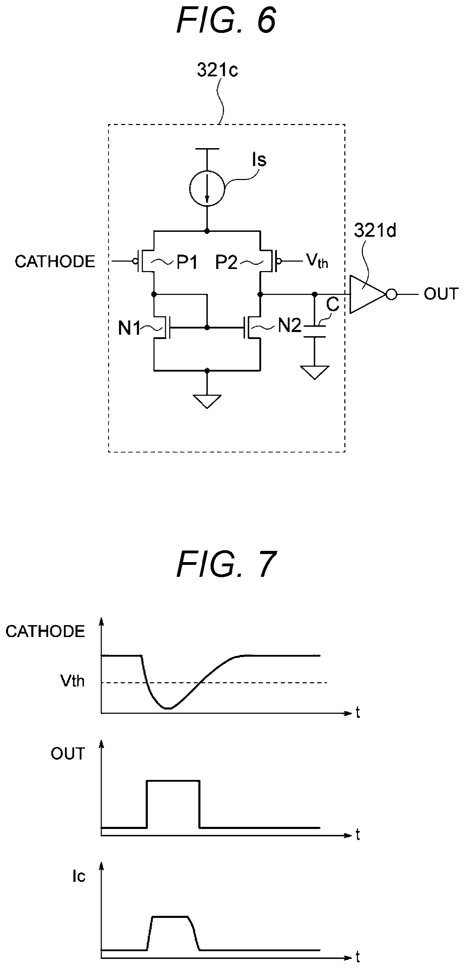

Fig. 6 is a circuit diagram of the comparator 321c according to the first embodiment. The comparator 321c illustrated in Fig. 4 includes MOS transistors P1 and P2, MOS transistors N1 and N2, a capacitor C, and a current source Is. Each of the MOS transistors P1 and P2 is a p-channel MOS transistor. On the other hand, each of the MOS transistors N1 and N2 is an n-channel MOS transistor.

In the comparator 321c according to the first embodiment, the sources of the MOS transistors P1 and P2 are connected to the current source Is. The MOS transistor N1 is connected in series to the MOS transistor P1. Furthermore, the MOS transistor N2 is connected in series to the MOS transistor P2. The gates of the MOS transistors N1 and N2 are connected to each other. Furthermore, also the drains of the MOS transistors P1 and N1 are connected to the gates of the MOS transistors N1 and N2.

The gate of the MOS transistor P1 corresponds to the positive input terminal (+) of the comparator 321c to which the cathode voltage CATHODE is input. Furthermore, the gate of the MOS transistor P2 corresponds to the negative input terminal (-) of the comparator 321c to which the threshold voltage Vth is input. Furthermore, the drains of the MOS transistor P2 and the MOS transistor N2 correspond to the output terminal of the comparator 321c. A capacitor C is connected between the drains of the MOS transistor P2 and the MOS transistor N2 and the input terminal of the inverter element 321d. The capacitor C stabilizes drain voltages of the MOS transistor P2 and the MOS transistor N2, that is, an output terminal voltage of the comparator 321c.

Fig. 7 is a flowchart for explaining operation of the comparator 321c and the inverter element 321d. Fig. 7 illustrates a waveform of the cathode voltage CATHODE of the photoelectric conversion element 321a, a waveform of the pixel signal OUT that is an output signal of the inverter element 321d, and a waveform of a consumption current Ic of the comparator 321c.

In the present embodiment, as illustrated in Fig. 7, in a period in which the cathode voltage CATHODE is lower than the threshold voltage Vth, the MOS transistors P1 and N2 are turned on, so that the output terminal of the comparator 321c is at the low level. As a result, the pixel signal OUT at the high level is output from the inverter element 321d.

On the contrary, in a period in which the cathode voltage CATHODE is higher than the threshold voltage Vth, the MOS transistor P2 is turned on and the MOS transistor N2 is turned off, so that the output terminal of the comparator 321c is at the high level. As a result, the pixel signal OUT at the low level is output from the inverter element 321d. At this time, in the comparator 321c, not only the MOS transistor N2 but also the MOS transistors P1 and N1 are turned off. For that reason, the current source Is is in an off state, and no current flows through the comparator 321c except for a leakage current. As a result, the consumption current Ic of the comparator 321c is almost zero.

According to the present embodiment, the cathode voltage CATHODE is input to the positive input terminal (+), and the threshold voltage Vth is input to the negative input terminal (-), whereby the consumption current of the comparator 321c when the photoelectric conversion element 321a does not react to incident light can be made almost zero. However, the circuit configuration of the comparator 321c is not limited to the circuit diagram illustrated in Fig. 6.

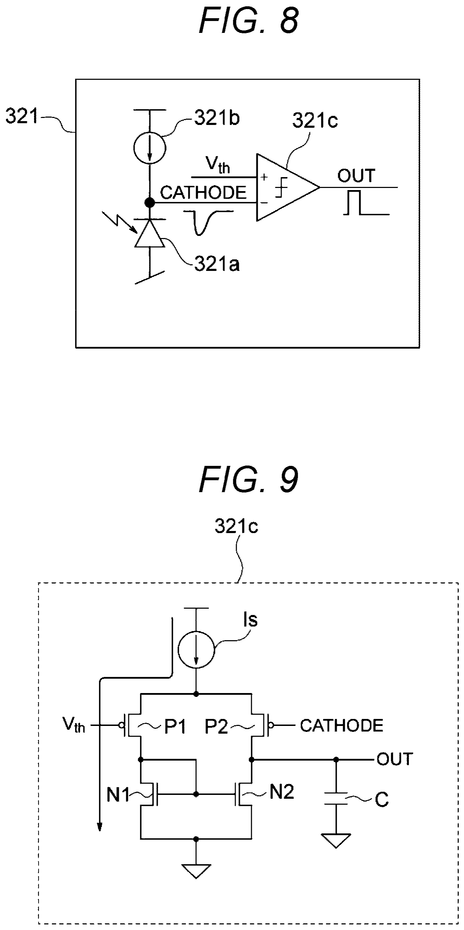

Fig. 8 is a circuit diagram of the pixel circuit 321 according to a modification of the first embodiment. In the present modification, the threshold voltage Vth is input to the positive input terminal (+) of the comparator 321c, and the cathode voltage CATHODE of the photoelectric conversion element 321a is input to the negative input terminal (-). Furthermore, the pixel circuit 321 according to the present modification is not provided with the inverter element 321d. For that reason, in the present modification, the output signal of the comparator 321c is the pixel signal OUT.

Fig. 9 is a circuit diagram of the comparator 321c according to the present modification. The circuit configuration of the comparator 321c according to the present modification is the same as that of the first embodiment illustrated in Fig. 6. On the other hand, the present modification is different from the first embodiment in that the cathode voltage CATHODE is input to the gate of the MOS transistor P2 and the threshold voltage Vth is input to the gate of the MOS transistor P1.

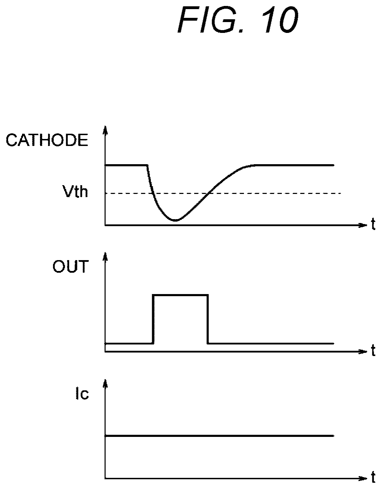

Fig. 10 is a flowchart for explaining operation of the comparator 321c according to the present modification. Fig. 10 illustrates a waveform of the cathode voltage CATHODE of the photoelectric conversion element 321a, a waveform of the pixel signal OUT that is an output signal of the comparator 321c, and a waveform of the consumption current Ic of the comparator 321c.

In the present modification, as illustrated in Fig. 10, in a period in which the cathode voltage CATHODE is lower than the threshold voltage Vth, only the MOS transistor P2 is turned on, so that the output terminal of the comparator 321c is at the high level. As a result, the pixel signal OUT at the high level is output from the comparator 321c.

Conversely, in a period in which the cathode voltage CATHODE is higher than the threshold voltage Vth, the MOS transistors P1 and N1 are turned on, and the MOS transistors P2 and N2 are turned off. As a result, the output terminal of the comparator 321c is at the low level. As a result, the pixel signal OUT at the low level is output from the comparator 321c.

In the present modification, as illustrated in Fig. 10, a current constantly flows through the comparator 321c regardless of a potential of the cathode voltage CATHODE. For that reason, power consumption of the comparator 321c is higher than that of the first embodiment described above. However, also in the present modification, since the reference voltage generation circuit 33 is provided, it is possible to perform calibration of the pulse width t_{pw} of the output signal of the reference voltage generation circuit 33 and each pixel circuit 321. Thus, similarly to the first embodiment, it is possible to make the pulse width t_{pw} of the pixel signal OUT constant, and suppress a decrease in photodetection accuracy regardless of the upper limit of the process, the voltage, and the temperature.

### (Second Embodiment)

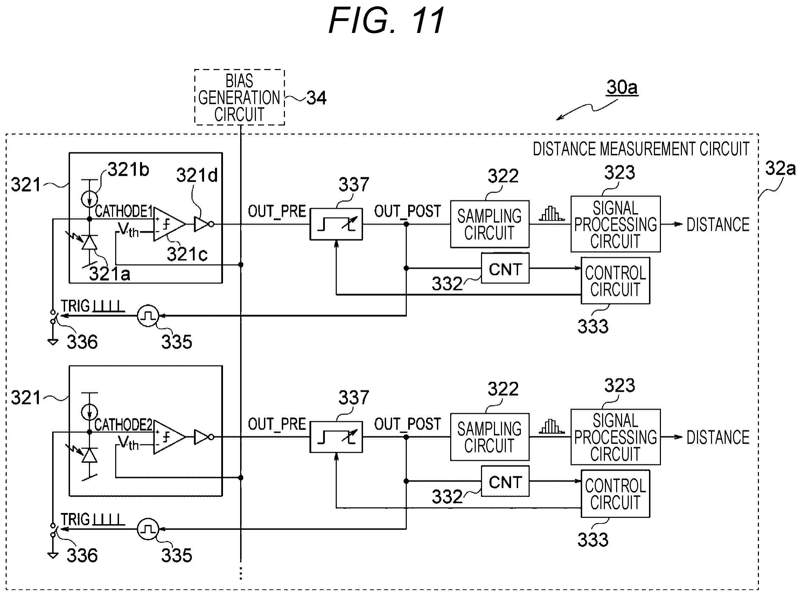

Fig. 11 is a block diagram illustrating a configuration of a main part of a photodetection device according to a second embodiment. In the present embodiment, components similar to those of the first embodiment are denoted by the same reference numerals, and a detailed description thereof will be omitted. A photodetection device 30a according to the present embodiment includes a distance measurement circuit 32a and a bias generation circuit 34.

First, a description will be given of the distance measurement circuit 32a. Also in the distance measurement circuit 32a, similarly to the first embodiment, the plurality of pixel circuits 321 is arranged in a two-dimensional array. Furthermore, in the present embodiment, the sampling circuit 322, the signal processing circuit 323, the counter circuit 332, the control circuit 333, the pulse generation circuit 335, the switch 336, and a pulse width adjustment circuit 337 are provided for each pixel circuit 321.

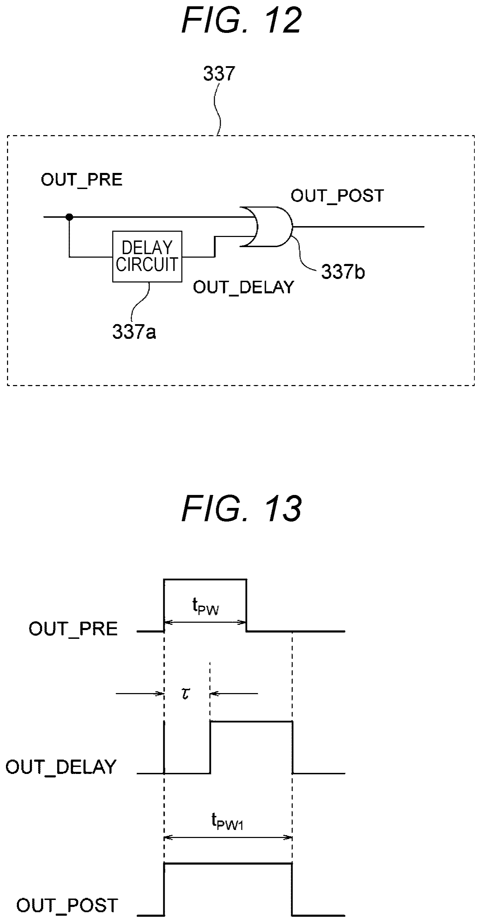

In the first embodiment described above, the counter circuit 332, the control circuit 333, the pulse generation circuit 335, and the switch 336 are provided in common for the plurality of pixel circuits 321, whereas in the present embodiment, one each of these circuit elements is provided for the pixel circuit 321. Furthermore, in the present embodiment, the pulse width adjustment circuit 337 is provided between the pixel circuit 321 and the sampling circuit 322. The pulse width adjustment circuit 337 adjusts the pulse width t_{pw} of the pixel signal OUT_PRE of the pixel circuit 321 by setting a delay time τ. Here, a description will be given of a circuit of the pulse width adjustment circuit 337 with reference to Fig. 12.

Fig. 12 is a circuit diagram of the pulse width adjustment circuit 337. Note that the circuit configuration of the pulse width adjustment circuit 337 is not limited to the circuit diagram illustrated in Fig. 12.

The pulse width adjustment circuit 337 illustrated in Fig. 12 includes a delay circuit 337a and an OR circuit 337b. In the delay circuit 337a, when the pixel signal OUT_PRE of the pixel circuit 321 is input to the delay circuit 337a, the pixel signal OUT_PRE is output from the delay circuit 337a as a delay signal OUT_DELAY after a lapse of the delay time τ. The pulse width adjustment circuit 337 includes, for example, a plurality of inverter elements connected together in series so that the delay time τ is variable.

The OR circuit 337b performs an OR logic operation on the pixel signal OUT_PRE and the delay signal OUT_DELAY. As a result, a calibrated signal OUT_POST obtained by adjustment of the pulse width t_{pw} of the pixel signal OUT_PRE is output from the output terminal of the OR circuit 337b as an output signal of the pulse width adjustment circuit 337.

Fig. 13 is a diagram illustrating an example of signal waveforms input to and output from the pulse width adjustment circuit 337. Fig. 13 illustrates waveforms of the pixel signal OUT_PRE, the delay signal OUT_DELAY, and the calibrated signal OUT_POST. When the OR circuit 337b performs the OR logic operation on the pixel signal OUT_PRE and the delay signal OUT_DELAY, as illustrated in Fig. 13, the pixel signal OUT_PRE having the pulse width t_{pw} is converted into the calibrated signal OUT_POST having a pulse width t_{pw1} longer than the pulse width t_{pw}.

Next, a description will be given of the bias generation circuit 34. The bias generation circuit 34 generates the threshold voltage Vth. Unlike the first embodiment, the threshold voltage Vth is a fixed value set in advance. The bias generation circuit 34 includes, for example, a constant voltage circuit. The threshold voltage Vth generated by the bias generation circuit 34 is input to the negative input terminal (-) of the comparator 321c of each pixel circuit 321.

Hereinafter, a description will be given of operation of the photodetection device 30a according to the present embodiment configured as described above. Here, a description will be given of calibration operation of the distance measurement circuit 32a.

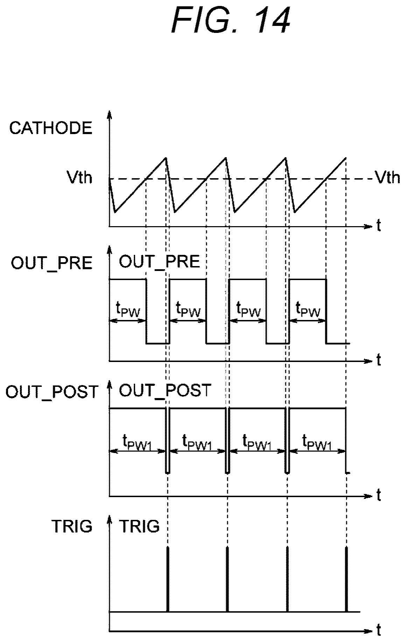

Fig. 14 is a timing chart for explaining the calibration operation of the distance measurement circuit 32a. Fig. 14 illustrates a waveform of each of the cathode voltage CATHODE of the photoelectric conversion element 321a, the pixel signal OUT_PRE, the calibrated signal OUT_POST, and the pulse signal TRIG.

Also in the present embodiment, similarly to the first embodiment, the switch 336 is turned on and off by the pulse signal TRIG of the pulse generation circuit 335 to oscillate the pixel signal OUT_PRE. The pixel signal OUT_PRE is converted into the calibrated signal OUT_POST by the pulse width adjustment circuit 337. In this way, the calibrated signal OUT_POST of a constant period is generated.

Subsequently, the counter circuit 332 measures the number of the calibrated signals OUT_POST within a certain period and notifies the control circuit 333 of the number. The control circuit 333 adjusts the delay time τ of the delay circuit 337a so that the number of counts of the calibrated signal OUT_POST is a predetermined number of counts. For example, when the number of the calibrated signals OUT_POST measured by the counter circuit 332 is larger than a predetermined number of counts, the control circuit 333 lengthens (extends) the delay time τ. Conversely, when the number of the calibrated signals OUT_POST is smaller than the predetermined number of counts, the control circuit 333 shortens (reduces) the delay time τ. As a result, the pulse width t_{pw1} of the calibrated signal OUT_POST can be made constant.

Note that the calibrated signal OUT_POST subjected to calibration is input to the sampling circuit 322. The sampling circuit 322 creates a histogram on the basis of the calibrated signal OUT_POST and outputs the histogram to the signal processing circuit 323. The signal processing circuit 323 obtains a distance to the subject 10 on the basis of the histogram generated by the sampling circuit 322 similarly to the first embodiment.

By disposing the pulse width adjustment circuit 337 at the subsequent stage of each pixel circuit 321 described above, it is possible to perform calibration of the pulse width of the pixel signal OUT_PRE for each pixel circuit. For that reason, it is possible to suppress a decrease in photodetection accuracy and further improve distance measurement accuracy as compared with the first embodiment.

Note that, in the present embodiment, an oscillator including the pulse generation circuit 335 and the switch 336 may be mounted in each pixel circuit 321. Also in this case, it is possible to individually perform calibration of the pulse width of the pixel signal OUT_PRE of each pixel circuit 321.

Furthermore, in the present embodiment, the cathode voltage CATHODE of the photoelectric conversion element 321a is input to the positive input terminal (+) of the comparator 321c, and the threshold voltage Vth is input to the negative input terminal (-), but this may be reversed. That is, the threshold voltage Vth may be input to the positive input terminal (+), and the cathode voltage CATHODE may be input to the negative input terminal (-). Also in this case, it is possible to perform calibration of the pulse width of the pixel signal OUT_PRE for each pixel circuit by the pulse width adjustment circuit 337.

### (Third Embodiment)

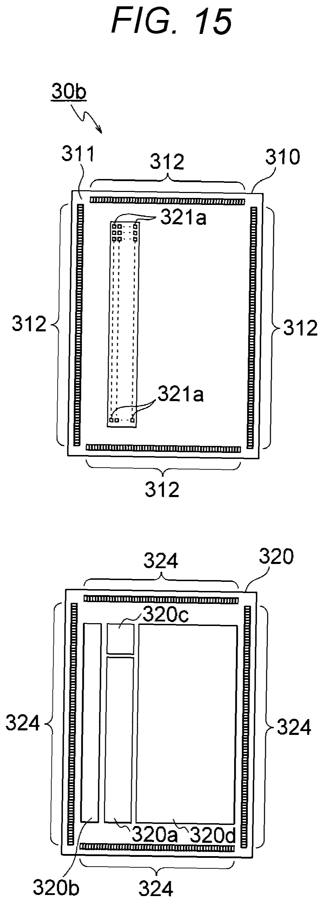

Fig. 15 is a perspective view illustrating an example of a structure of a photodetection device according to a third embodiment. In a photodetection device 30b according to the present embodiment, a first semiconductor substrate 310 and a second semiconductor substrate 320 stacked on the lower side of the first semiconductor substrate 310 are disposed in a distributed manner. The first semiconductor substrate 310 and the second semiconductor substrate 320 are electrically connected together through a connection portion such as a via (VIA), a Cu-Cu bonding, or a bump. That is, the first semiconductor substrate 310 and the second semiconductor substrate 320 are bonded together by any of a chip on chip (CoC) method, a chip on wafer (CoW) method, and a wafer on wafer (WoW) method.

On a light receiving surface 311 of the first semiconductor substrate 310, the photoelectric conversion elements 321a of the respective pixel circuits 321 are arranged in a two-dimensional array. Furthermore, a pad region 312 is disposed on an outer peripheral portion of the light receiving surface 311. In the pad region 312, a pad is formed for electrical connection with the second semiconductor substrate 320.

On the other hand, the second semiconductor substrate 320 includes a first circuit region 320a, a second circuit region 320b, a third circuit region 320c, and a fourth circuit region 320d on a surface facing the first semiconductor substrate 310. Furthermore, a pad region 324 is disposed on an outer peripheral portion of the surface. In the pad region 324, a pad is formed for electrical connection with the first semiconductor substrate 310.

In the first circuit region 320a, circuit elements other than the photoelectric conversion element 321a of each pixel circuit 321, that is, the current source 321b, the comparator 321c, and the inverter element 321d are disposed. In the second circuit region 320b, the bias generation circuit 34 described in the second embodiment, a power supply circuit, a pixel control circuit, and the like are disposed. The reference voltage generation circuit 33 is disposed in the third circuit region 320c. In the fourth circuit region 320d, the sampling circuit 322 and the signal processing circuit 323 are disposed. In the present embodiment, an array of the photoelectric conversion elements 321a is formed immediately above the first circuit region 320a and the third circuit region 320c. Furthermore, the first circuit region 320a and the third circuit region 320c are disposed between the second circuit region 320b and the fourth circuit region 320d. That is, the second circuit region 320b (bias generation circuit 34) is formed along the long side of the first circuit region 320a having a rectangular shape.

According to the present embodiment described above, similarly to the first embodiment or the second embodiment, it is possible to perform calibration of the pulse width of the pixel signal of the pixel circuit 321, and thus, it is possible to make the pulse width t_{pw} of the pixel signal OUT constant, and suppress a decrease in photodetection accuracy regardless of the upper limit of the process, the voltage, and the temperature.

Moreover, according to the present embodiment, in the pixel circuit 321, the photoelectric conversion element 321a is disposed on the first semiconductor substrate 310, and the remaining circuit elements are disposed on the second semiconductor substrate 320 bonded to the first semiconductor substrate 310. As a result, an arrangement area of the photoelectric conversion element 321a is increased as compared with a case where all the circuit elements of the pixel circuit 321 are disposed on one substrate. As a result, a sufficient light receiving area can be secured.

### (Fourth Embodiment)

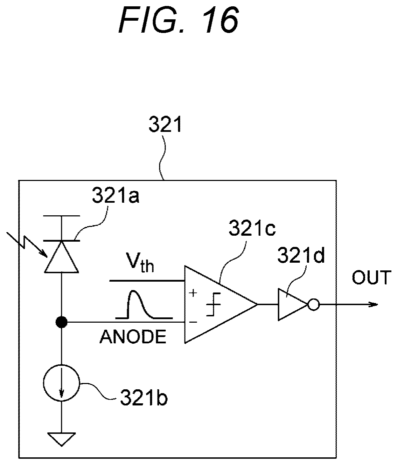

Fig. 16 is a circuit diagram of the pixel circuit according to a fourth embodiment. The present embodiment is different from the first embodiment in a connection form between the photoelectric conversion element 321a and the comparator 321c. In the first embodiment, the cathode of the photoelectric conversion element 321a is connected to the negative input terminal (-) of the comparator 321c.

On the other hand, in the pixel circuit 321 according to the present embodiment, as illustrated in Fig. 16, the anode of the photoelectric conversion element 321a is connected to the negative input terminal (-) of the comparator 321c. Furthermore, the anode of the photoelectric conversion element 321a is grounded through the current source 321b. Furthermore, in the present embodiment, the comparator 321c compares an anode voltage ANODE output from the photoelectric conversion element 321a with the threshold voltage Vth. A comparison result is inverted by the inverter element 321d and output as the pixel signal OUT.

Also in the present embodiment, calibration of the pulse width t_{pw} of the pixel signal OUT is performed by the reference voltage generation circuit 33 similarly to the first embodiment. For that reason, it is possible to make the pulse width t_{pw} of the pixel signal OUT constant, and suppress a decrease in photodetection accuracy regardless of the upper limit of the process, the voltage, and the temperature.

### (Fifth Embodiment)

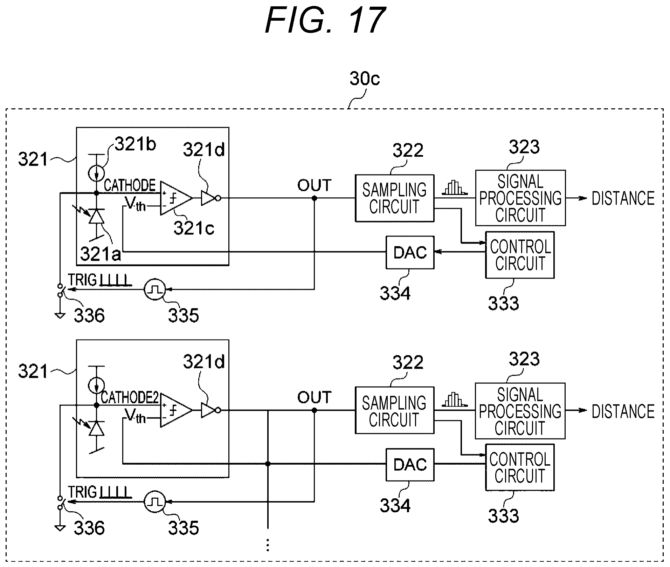

Fig. 17 is a circuit diagram illustrating a configuration of a photodetection device according to a fifth embodiment. In the present embodiment, components similar to those of the first embodiment are denoted by the same reference numerals, and a detailed description thereof will be omitted. Also in a photodetection device 30c according to the present embodiment, the plurality of pixel circuits 321 is arranged in a two-dimensional array. Furthermore, in the present embodiment, the sampling circuit 322, the signal processing circuit 323, the control circuit 333, the DAC 334, the pulse generation circuit 335, and the switch 336 are provided for each pixel circuit 321.

In the photodetection device 30c according to the present embodiment, the control circuit 333 performs calibration of the pulse width t_{pw} of the pixel signal OUT of the pixel circuit 321 by using the pulse generation circuit 335 and the switch 336, and changes the potential of the threshold voltage Vth in accordance with a light receiving environment of the photoelectric conversion element 321a.

For example, the control circuit 333 first determines the light receiving environment on the basis of an average value of the histogram generated by the sampling circuit 322. For example, in a case where the average value of the histogram is smaller than a standard value set in advance, the light receiving environment is determined as a first light receiving environment in which disturbance light is weak and the distance to the subject 10 is long. On the other hand, in a case where the average value of the histogram is larger than the standard value, the light receiving environment is determined as a second light receiving environment in which disturbance light id strong and the distance to the subject 10 is short.

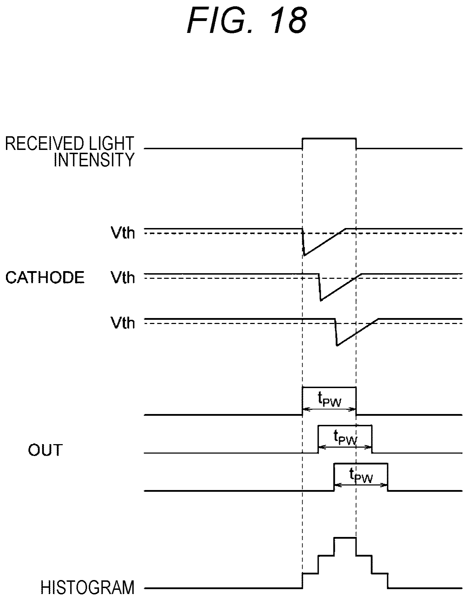

Fig. 18 is a timing chart for explaining operation of the photodetection device 30c in the first light receiving environment. Fig. 18 illustrates a waveform of each of a received light intensity of the photoelectric conversion element 321a, the cathode voltage CATHODE, and the pixel signal OUT, and a histogram generated by the sampling circuit 322. Furthermore, Fig. 18 illustrates results of reaction of the photoelectric conversion element 321a for three times.

In the first light receiving environment, the disturbance light is weak, and the distance to the subject 10 is long. For that reason, the light intensity received in the photoelectric conversion element 321a also decreases. In this case, the control circuit 333 controls the DAC 334 so that the potential of the threshold voltage Vth increases. The potential of the threshold voltage Vth increases, whereby the pulse width t_{pw} of the pixel signal OUT is about the same as the pulse width of the cathode voltage CATHODE, in other words, the pulse width of the laser light emitted from the light source device 20. As a result, all the pixel signals OUT indicating results of receiving the reflected light from the subject 10 by the photoelectric conversion element 321a are added to the histogram. For that reason, even in a case where the distance to the subject 10 is long and the intensity of the reflected light from the subject 10 is weak as in the first light receiving environment, a peak value of the reflected light can be identified in the histogram. As a result, distance measurement is possible.

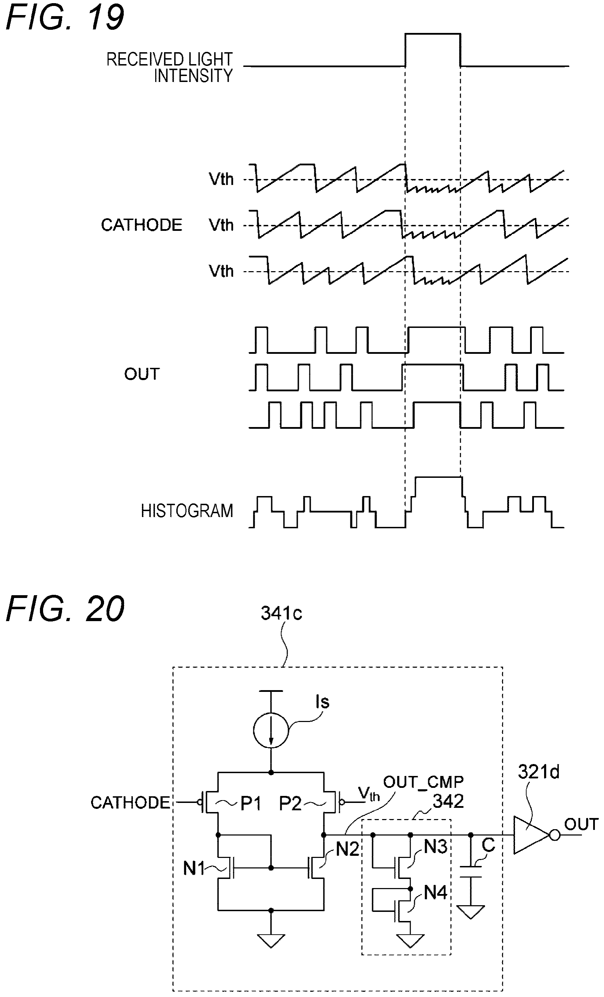

Fig. 19 is a timing chart for explaining operation of the photodetection device 30c in the second light receiving environment. Similarly to Fig. 18, Fig. 19 also illustrates a waveform of each of the received light intensity of the photoelectric conversion element 321a, the cathode voltage CATHODE, and the pixel signal OUT, and a histogram generated by the sampling circuit 322. Furthermore, Fig. 19 also illustrates results of reaction of the photoelectric conversion element 321a for three times.

In the second light receiving environment, the disturbance light is stronger than in the first light receiving environment, and the distance to the subject 10 is shorter than in the first light receiving environment. For that reason, the light intensity received in the photoelectric conversion element 321a also increases. In this case, the control circuit 333 controls the DAC 334 so that the potential of the threshold voltage Vth decreases. In this case, the pulse width t_{pw} of the pixel signal OUT is shortened. As a result, accumulation of the pixel signal OUT due to the disturbance light is difficult, and thus saturation of the histogram due to the disturbance light can be suppressed.

On the other hand, when the potential of the threshold voltage Vth decreases, reaction is likely to occur again during recovery of the cathode voltage CATHODE. For that reason, in the case of the second light receiving environment, the photoelectric conversion element 321a reacts a plurality of times in a period in which the reflected light is emitted, and the cathode voltage CATHODE is maintained at a low voltage. In this case, even if the threshold voltage Vth is decreased, a change in the pulse width t_{pw} of the pixel signal OUT due to the reflected light is small.

According to the present embodiment described above, the control circuit adjusts the threshold voltage Vth in accordance with the light receiving environment, whereby the distance measurement can be performed in a wide disturbance light intensity range and distance range.

### (Sixth Embodiment)

Fig. 20 is a circuit diagram of a comparator according to a sixth embodiment. Circuit elements similar to those of the comparator 321c according to the first embodiment illustrated in Fig. 6 are denoted by the same reference numerals, and a detailed description thereof will be omitted.

A comparator 341c according to the present embodiment further includes a clamp circuit 342 in addition to circuit elements similar to those of the comparator 321c according to the first embodiment. The clamp circuit 342 includes a MOS transistor N3 and a MOS transistor N4 connected together in series. Furthermore, in the MOS transistor N3 and the MOS transistor N4, the drain and the gate are connected together. That is, the MOS transistor N3 and the MOS transistor N4 are diode-connected together.

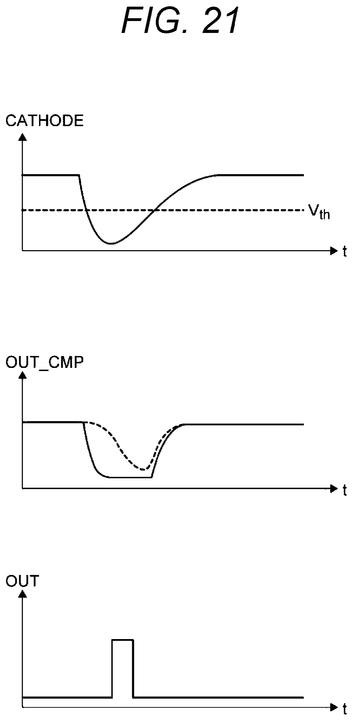

Fig. 21 is a diagram illustrating an example of a voltage waveform when the MOS transistor N2 is degraded in the comparator 321c according to the first embodiment. The upper part of Fig. 21 illustrates waveforms of the cathode voltage CATHODE of the photoelectric conversion element 321a and the threshold voltage Vth. The middle part of Fig. 2 illustrates a waveform of an output voltage OUT_CMP of the comparator 341c. The lower part of Fig. 2 illustrates a waveform of the pixel signal OUT output from the inverter element 321d. When the MOS transistor N2 degrades over time, it is difficult to accurately copy a current in a current mirror circuit including the MOS transistors P1, P2, N1, and N2. For that reason, as illustrated in Fig. 21, the falling of the output voltage OUT_CMP becomes gentle, and as a result, the pulse width of the pixel signal OUT becomes narrow.

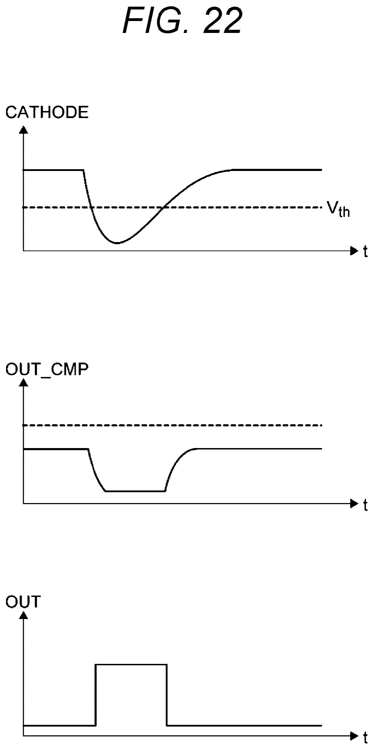

Fig. 22 is a diagram illustrating an example of a voltage waveform when the MOS transistor N2 is degraded in the comparator 341c according to the sixth embodiment. The comparator 321c according to the present embodiment is provided with the clamp circuit 342 as a degradation countermeasure circuit for the MOS transistor N2. The clamp circuit 342 clamps the drain voltage of the MOS transistor N2, that is, the output voltage OUT_CMP. As a result, as illustrated in Fig. 22, degradation of the MOS transistor N2 is suppressed, and the pulse width of the pixel signal OUT is not narrowed.

Thus, according to the present embodiment, reliability of the comparator can be improved.

### <Application example to mobile body>

The technology according to the present disclosure (the present technology) can be applied to various products. For example, the technology according to the present disclosure may be embodied in the form of a device to be mounted on a mobile body of any kind, such as an automobile, an electric vehicle, a hybrid electric vehicle, a motorcycle, a bicycle, a personal mobility, an airplane, a drone, a vessel, or a robot.

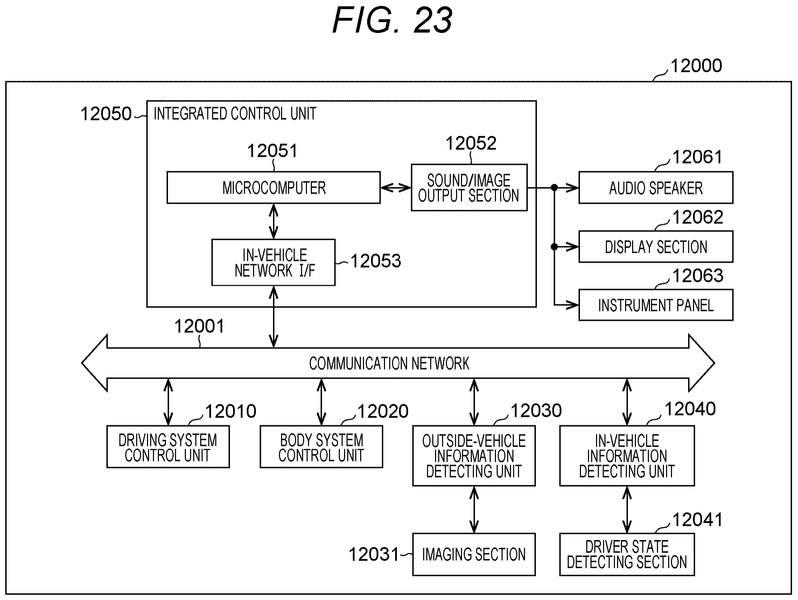

Fig. 23 is a block diagram illustrating a schematic configuration example of a vehicle control system that is an example of a mobile body control system to which the technology of the present disclosure can be applied.

The vehicle control system 12000 includes a plurality of electronic control units connected to each other via a communication network 12001. In the example illustrated in Fig. 23, the vehicle control system 12000 includes a driving system control unit 12010, a body system control unit 12020, an outside-vehicle information detecting unit 12030, an in-vehicle information detecting unit 12040, and an integrated control unit 12050. Furthermore, as a functional configuration of the integrated control unit 12050, a microcomputer 12051, a sound/image output section 12052, and an in-vehicle network interface (I/F) 12053 are illustrated.

The driving system control unit 12010 controls the operation of devices related to the driving system of the vehicle in accordance with various kinds of programs. For example, the driving system control unit 12010 functions as a control device for a driving force generating device for generating the driving force of the vehicle such as an internal combustion engine or a driving motor, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound or an image to an output device that can visually or auditorily notify an occupant or the outside of the vehicle of information. In the example in Fig. 23, an audio speaker 12061, a display section 12062, and an instrument panel 12063 are exemplified as the output device. The display section 12062 may include, for example, at least one of an on-board display or a head-up display.

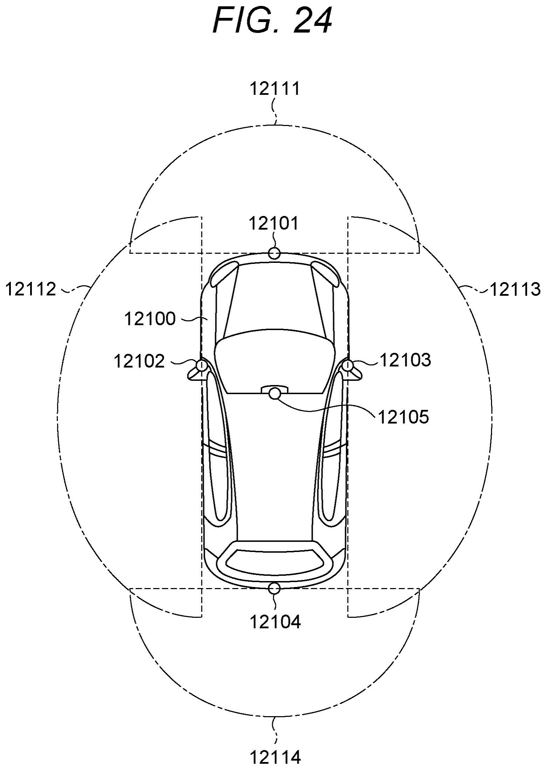

Fig. 24 is a diagram illustrating an example of installation positions of the imaging section 12031.

In Fig. 24, the imaging section 12031 includes imaging sections 12101, 12102, 12103, 12104, and 12105.

The imaging sections 12101, 12102, 12103, 12104, and 12105 are provided, for example, at positions such as the front nose, the sideview mirrors, the rear bumper, the back door, and an upper portion of the windshield within an interior of a vehicle 12100. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Note that Fig. 24 illustrates an example of imaging ranges of the imaging sections 12101 to 12104. An imaging range 12111 represents the imaging range of the imaging section 12101 provided to the front nose, imaging ranges 12112 and 12113 respectively represent the imaging ranges of the imaging sections 12102 and 12103 provided to the sideview mirrors, and an imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the above, an example has been described of the vehicle control system to which the technology according to the present disclosure is applicable. The technology according to the present disclosure can be applied to, for example, the imaging section 12031 among the components described above. Specifically, the photodetection device 30 can be applied to the imaging section 12031. By applying the technology according to the present disclosure, it is possible to obtain a captured image with higher distance measurement accuracy, and thus, improve safety.

Note that the present technology can have the following configurations.
(1) A photodetection device including:
   a photoelectric conversion element that photoelectrically converts incident light;
   a comparator that compares an output voltage of the photoelectric conversion element with a threshold voltage;
   a pulse generation circuit that uses a pixel signal indicating a comparison result by the comparator to generate a pulse signal having a pulse width shorter than a pulse width of the pixel signal; and
   a switch that is connected to the photoelectric conversion element and is turned on and off on the basis of the pulse signal.
(2) The photodetection device according to (1), further including:
   a pixel circuit including a first photoelectric conversion element that photoelectrically converts the incident light and a first comparator that compares an output voltage of the first photoelectric conversion element with a threshold voltage, the pixel circuit outputting a first pixel signal indicating a comparison result by the first comparator; and
   a pixel replica circuit including a second photoelectric conversion element connected to the switch and a second comparator that compares an output voltage of the second photoelectric conversion element with the threshold voltage, in which a second pixel signal indicating a comparison result by the second comparator is input to the pulse generation circuit.
(3) The photodetection device according to (2), further including a control circuit that controls a potential of the threshold voltage on the basis of a result of counting the second pixel signal within a certain period.
(4) The photodetection device according to (3), in which the control circuit increases the potential of the threshold voltage when the number of counts of the second pixel signal is larger than a predetermined number of counts.
(5) The photodetection device according to (3) or (4), in which the control circuit decreases the potential of the threshold voltage when the number of counts of the second pixel signal is smaller than a predetermined number of counts.
(6) The photodetection device according to any of (3) to (5), further including:
   a counter circuit that measures the number of the second pixel signals; and
   a digital analog converter (DAC) that adjusts the potential of the threshold voltage in accordance with control of the control circuit.
(7) The photodetection device according to (1), further including:
   a pulse width adjustment circuit that outputs a calibrated signal obtained by adjusting a pulse width of the pixel signal to the pulse generation circuit; and
   a control circuit that causes the pulse width adjustment circuit to adjust the pulse width on the basis of a result of counting the calibrated signal within a certain period.
(8) The photodetection device according to (7), in which
   the pulse width adjustment circuit includes:
   a delay circuit that outputs the pixel signal input, as a delay signal after a lapse of a delay time; and
   an OR circuit that performs an OR logic operation on the pixel signal and the delay signal.
(9) The photodetection device according to (8), in which the control circuit controls the delay time on the basis of a result of counting the calibrated signal.
(10) The photodetection device according to (9), in which the control circuit lengthens the delay time when the number of counts of the calibrated signal is larger than a predetermined number of counts.
(11) The photodetection device according to (9) or (10), in which the control circuit shortens the delay time when the number of counts of the calibrated signal is smaller than a predetermined number of counts.
(12) The photodetection device according to any of (1) to (11), further including:
   a first semiconductor substrate on which the photoelectric conversion element is disposed; and
   a second semiconductor substrate on which the comparator, the pulse generation circuit, and the switch are disposed, the second semiconductor substrate being stacked and bonded to the first semiconductor substrate.
(13) The photodetection device according to (1), in which the photoelectric conversion element is an avalanche photodiode.
(14) The photodetection device according to (13), in which a cathode of the photoelectric conversion element is connected to a positive input terminal of the comparator.
(15) The photodetection device according to (13), in which a cathode of the photoelectric conversion element is connected to a negative input terminal of the comparator.
(16) The photodetection device according to (13), in which an anode of the photoelectric conversion element is connected to a negative input terminal of the comparator.
(17) The photodetection device according to (1), further including a control circuit that controls a potential of the threshold voltage in accordance with a light receiving environment of the photoelectric conversion element.
(18) The photodetection device according to (17), in which
   the control circuit determines the light receiving environment as a first light receiving environment or a second light receiving environment in which disturbance light is stronger than in the first light receiving environment and a distance to a subject is shorter, on the basis of an average value of a histogram of the pixel signal within a certain period, and
   the control circuit increases the potential of the threshold voltage when the light receiving environment is the first light receiving environment and decreases the potential of the threshold voltage when the light receiving environment is the second light receiving environment.
(19) A photodetection device including:
   a photoelectric conversion element that photoelectrically converts incident light; and
   a comparator that compares an output voltage of the photoelectric conversion element with a variable threshold voltage, in which
   the output voltage is input to a positive input terminal of the comparator, and the threshold voltage is input to a negative input terminal of the comparator.
(20) A distance measuring system including:
   a light source device that emits light toward a subject; and
   a photodetection device that receives reflected light obtained by reflection of the light on the subject, in which
   the photodetection device includes:
      a photoelectric conversion element that photoelectrically converts the reflected light;
      a comparator that compares an output voltage of the photoelectric conversion element with a threshold voltage;
      a pulse generation circuit that uses a pixel signal indicating a comparison result by the comparator to generate a pulse signal having a pulse width shorter than a pulse width of the pixel signal; and
      a switch that is connected to the photoelectric conversion element and is turned on and off on the basis of the pulse signal.

### REFERENCE SIGNS LIST

- 1: Distance measuring system
- 20: Light source device
- 30: Photodetection device
- 310: First semiconductor substrate
- 320: Second semiconductor substrate
- 321: Pixel circuit
- 321a, 331a: Photoelectric conversion element
- 321c, 331c: Comparator
- 331: Pixel replica circuit
- 332: Counter circuit
- 333: Control circuit
- 334: DAC
- 335: Pulse generation circuit
- 336: Switch
- 337: Pulse width adjustment circuit
- 337a: Delay circuit
- 337b: OR circuit

## Claims

1. A photodetection device comprising:
a photoelectric conversion element that photoelectrically converts incident light;
a comparator that compares an output voltage of the photoelectric conversion element with a threshold voltage;
a pulse generation circuit that uses a pixel signal indicating a comparison result by the comparator to generate a pulse signal having a pulse width shorter than a pulse width of the pixel signal; and
a switch that is connected to the photoelectric conversion element and is turned on and off on a basis of the pulse signal.

2. The photodetection device according to claim 1, further comprising:
a pixel circuit including a first photoelectric conversion element that photoelectrically converts the incident light and a first comparator that compares an output voltage of the first photoelectric conversion element with a threshold voltage, the pixel circuit outputting a first pixel signal indicating a comparison result by the first comparator; and
a pixel replica circuit including a second photoelectric conversion element connected to the switch and a second comparator that compares an output voltage of the second photoelectric conversion element with the threshold voltage, wherein a second pixel signal indicating a comparison result by the second comparator is input to the pulse generation circuit.

3. The photodetection device according to claim 2, further comprising a control circuit that controls a potential of the threshold voltage on a basis of a result of counting the second pixel signal within a certain period.

4. The photodetection device according to claim 3, wherein the control circuit increases the potential of the threshold voltage when a number of counts of the second pixel signal is larger than a predetermined number of counts.

5. The photodetection device according to claim 3, wherein the control circuit decreases the potential of the threshold voltage when a number of counts of the second pixel signal is smaller than a predetermined number of counts.

6. The photodetection device according to claim 3, further comprising:
a counter circuit that measures a number of the second pixel signals; and
a digital analog converter (DAC) that adjusts the potential of the threshold voltage in accordance with control of the control circuit.

7. The photodetection device according to claim 1, further comprising:
a pulse width adjustment circuit that outputs a calibrated signal obtained by adjusting a pulse width of the pixel signal to the pulse generation circuit; and
a control circuit that causes the pulse width adjustment circuit to adjust the pulse width on a basis of a result of counting the calibrated signal within a certain period.

8. The photodetection device according to claim 7, wherein
the pulse width adjustment circuit includes:
a delay circuit that outputs the pixel signal input, as a delay signal after a lapse of a delay time; and
an OR circuit that performs an OR logic operation on the pixel signal and the delay signal.

9. The photodetection device according to claim 8, wherein the control circuit controls the delay time on a basis of a result of counting the calibrated signal.

10. The photodetection device according to claim 9, wherein the control circuit lengthens the delay time when a number of counts of the calibrated signal is larger than a predetermined number of counts.

11. The photodetection device according to claim 9, wherein the control circuit shortens the delay time when a number of counts of the calibrated signal is smaller than a predetermined number of counts.

12. The photodetection device according to claim 1, further comprising:
a first semiconductor substrate on which the photoelectric conversion element is disposed; and
a second semiconductor substrate on which the comparator, the pulse generation circuit, and the switch are disposed, the second semiconductor substrate being stacked and bonded to the first semiconductor substrate.

13. The photodetection device according to claim 1, wherein the photoelectric conversion element is an avalanche photodiode.

14. The photodetection device according to claim 13, wherein a cathode of the photoelectric conversion element is connected to a positive input terminal of the comparator.

15. The photodetection device according to claim 13, wherein a cathode of the photoelectric conversion element is connected to a negative input terminal of the comparator.

16. The photodetection device according to claim 13, wherein an anode of the photoelectric conversion element is connected to a negative input terminal of the comparator.

17. The photodetection device according to claim 1, further comprising a control circuit that controls a potential of the threshold voltage in accordance with a light receiving environment of the photoelectric conversion element.

18. The photodetection device according to claim 17, wherein
the control circuit determines the light receiving environment as a first light receiving environment or a second light receiving environment in which disturbance light is stronger than in the first light receiving environment and a distance to a subject is shorter, on a basis of an average value of a histogram of the pixel signal within a certain period, and
the control circuit increases the potential of the threshold voltage when the light receiving environment is the first light receiving environment and decreases the potential of the threshold voltage when the light receiving environment is the second light receiving environment.

19. A distance measuring system comprising:
a light source device that emits light toward a subject; and
a photodetection device that receives reflected light obtained by reflection of the light on the subject, wherein
the photodetection device includes:
a photoelectric conversion element that photoelectrically converts the reflected light;
a comparator that compares an output voltage of the photoelectric conversion element with a threshold voltage;
a pulse generation circuit that uses a pixel signal indicating a comparison result by the comparator to generate a pulse signal having a pulse width shorter than a pulse width of the pixel signal; and
a switch that is connected to the photoelectric conversion element and is turned on and off on a basis of the pulse signal.
